# EUROPEAN PATENT APPLICATION

(11) **EP 4 746 207 A1**
(43) Date of publication of application: **20.05.2026**
(21) Application number: 25217057.6
(22) Date of filing: 19.11.2025
(51) Int. Cl.: H01R 12/58, H05K 1/00, H05K 1/18, H10W 74/01, H10W 40/25, H10W 74/10, H10W 90/00, H05K 1/184

(54) **A METHOD OF MANUFACTURING A SEMICONDUCTOR PACKAGE HAVING A CONNECTION PIN AND CORRESPONDING SEMICONDUCTOR PACKAGE**

(30) Priority: 19.11.2024 NL 2039119
(71) Applicant: Nexperia B.V., 6534 AB Nijmegen (NL)
(72) Inventor: Gong, Wei, Manchester (GB); Cao, Pulong, Shanghai (CN); Wang, Ruitong, Shanghai (CN)
(74) Representative: Pjanovic, Ilija

(57) **Abstract**

A method of manufacturing a semiconductor package having a connection pin for creating a connection between the semiconductor package and an external circuit, comprising the steps of, providing said semiconductor package having a bond pad for receiving a rivet; mounting said rivet onto the bond pad of the semiconductor package, wherein the rivet is arranged to receive, in a rivet cavity of said rivet, said connection pin for creating said connection; molding the semiconductor package, having said mounted rivet, with a molding compound, wherein, during said molding, an opening of said rivet is covered by a cover, said opening leading to said rivet cavity; removing the cover and providing said connection pin in the rivet cavity via the rivet opening of said rivet.

## Description

### Technical Field

The present disclosure relates to semiconductor packages having a connection pin, more specifically using a rivet for receiving the connection pin.

### Background

In power module designs, positioning connection pins on the top surface of the molded power module offers several advantages. One of the primary benefits is the ease of connection, as the gate driver board can be directly mounted from above, simplifying the installation process and significantly reducing assembly time and effort. Additionally, this design approach shortens the distance between the gate driver and the power module, which helps to minimize control loop parasitic inductance, thereby enhancing the overall performance and reliability of the system. By eliminating the need for complex alignment procedures, the top-down connection method improves efficiency and reduces costs. However, traditional molded power modules encounter significant challenges when attempting to integrate signal pins on the top surface. The main issue arises during the molding process, where the presence of a molding cavity at the top complicates the incorporation of signal pins without risking the intrusion of Epoxy Molding Compound (EMC) material. If the molding cavity remains open to accommodate the pin, there is a high likelihood that EMC material will seep into the gap between the pin and the cavity, potentially compromising the module's structural integrity and reliability.

An additional step of removing the excess molding compound at the signal pin may be required to remove the EMC material that has accessed the gap between the pin and the cavity.

### Summary

It would be advantageous to achieve a semiconductor package having a connection pin without having any EMC material attached thereto. It would further be advantageous to achieve a corresponding method of manufacturing such a semiconductor package.

In order to remove such a step of removing the molding compound, a rivet may be used during the molding process, wherein the rivet receives a signal pin after the step of molding. However, this may result in the rivet being covered by the molding material nonetheless, or material seeping into the cavity of the rivet.

It would therefore be advantageous to achieve a semiconductor package having a rivet which may prevent molding compound covering the rivet cavity and allowing the signal pin to be provide in said rivet cavity without a need for a further grinding step for removing the EMC material.

In a first aspect of the present disclosure, there is provided a method of manufacturing a semiconductor package having a connection pin for creating a connection between the semiconductor package and an external circuit, comprising the steps of,
- providing said semiconductor package having a bond pad for receiving a rivet;
- mounting said rivet onto the bond pad of the semiconductor package, wherein the rivet is arranged to receive, in a rivet cavity of said rivet, said connection pin for creating said connection;
- molding the semiconductor package, having said mounted rivet, with a molding compound, wherein, during said molding, an opening of said rivet is covered by a cover, said opening leading to said rivet cavity;
- removing the cover and providing said connection pin in the rivet cavity via the rivet opening of said rivet.

The inventors have found that it may be beneficial to use a rivet which may be provided on the bond pad of the semiconductor package. This rivet comprises a rivet cavity which is provided to receive the connection pin. The connection pin may provide a power or a signal to the semiconductor package and is arranged to conduct current.

This pin is provided after the step of molding, because of the problems encountered by the prior art. During the molding step, a cover is provided on top of the rivet for covering the rivet cavity. This prevents any molding compound seeping in the rivet cavity. After this step the cover may be removed which allows the connection pin to be placed in the cavity. More specifically the pin may have a slightly larger diameter than the rivet cavity, resulting in it needing to be pushed into the rivet cavity.

It it to be understood that the cover is to cover at least a part of the top surface of the rivet, i.e. the part that at least covers the rivet cavity.

In an example of the disclosure, the step of mounting a rivet comprises:
- mounting said rivet, said rivet comprising an electrically conductive material arranged for providing an electrical connection between the bond pad and the connection pin.

The inventors have found that it may beneficial to provide an electrically conductive material for the rivet, as it allows an electrical connection between the connection pin and the bond pad. This may be beneficial as the connection pin may not be connected, i.e. touching, to said bond pad. Then therefore, to still provide electrical connection between the connection pin and the bond pad, the rivet may comprise electrically conductive material.

In an example of the disclosure, the step of providing said connection pin comprises:
- providing said connection pin in the rivet cavity by clamping said connection pin by said rivet.

The inventors have found that it may be beneficial to provide the rivet, wherein the rivet is arranged, due to the difference in diameter, to clamp the connection pin in place. This then allows an electrical connection between external circuitry and the semiconductor package without needing a step of soldering the connection pin, or any other connection step.

In an example of the disclosure, the step of providing said connection pin comprises:
- providing said connection pin in the rivet cavity such that said cavity is partly filled.

It may be provided that the connection pin does not reach the bond pad, this is because of the clamping of the connection pin, wherein if the connection pin is to be clamped into place, the connection pin needs to be pushed as tightly as possible. This means that is unlikely for the connection pin to fully fill in the rivet cavity. This is because if the connection pin fully fills the rivet cavity, there is a high likelihood that the connection pin is still loose. This is unwanted. Therefore, the rivet cavity may be only partly filled.

In an example of the disclosure said method comprises the step of:
- providing said cover on said rivet before said step of molding.

Prior to the step of molding, a cover is to be provided on the rivet. As mentioned, this is to prevent molding compound to enter the rivet cavity.

In an example of the disclosure, said step of providing said cover comprises any of:
- providing a film on said rivet;
- providing a spring-clip on said rivet, wherein, during said step of molding, said spring-clip is pushed thereby providing a sealing of said rivet.

When providing a film on said rivet, this may be a film covering at least part of the rivet top surface and covering the rivet cavity. It may alternatively be provided when a top and bottom cavity is provided, which encapsulate the semiconductor package during the molding step and serve as a mold for the molding compound to be placed into. The film here is attached to the top cavity surface facing the rivets. This film may be pushed to the rivets, such that seeping in of molding compound is prevented. This film may fully cover the top cavity surface or at least partly cover the top cavity surface, at least covering the rivet cavity of the rivet. In the case of a plurality of rivets present on the semiconductor package, the rivet top surfaces may be substantially aligned.

The spring clip may be closed by pushing the top cavity against the spring clip. This provides an alternative method of providing a cover, wherein the spring clip may be removed relatively quickly after the step of molding. This spring clip is held in place by the exerted force of the top cavity of the mold during the step of molding.

In an example of the disclosure, said method comprises any of the steps of:
- pushing a holder block against said cover, or
- pushing a holder block, being said cover, against said rivet,
wherein said holder block is arranged for preventing, during said step of molding, molding compound to be provided above said rivet.

Here, holder blocks are provided against said cover, or may be said cover. The holder blocks may, for example, be pushed against the rivet.

This, as with the other examples, prevents molding compound entering the rivet cavity during the molding step. It may be provided that the top surfaces of a plurality of rivets are not aligned and have a vertical offset. In this case, it may be beneficial to provide holder blocks that have a spring attached. This results in a modular positioning of the holder blocks, while pushing the holder blocks against the rivet, preventing said molding compound entering the rivet. Furthermore, due to the shape of the holder block, the molding compound also may not be provided above said rivet, on top of the cover.

In an example of the disclosure, wherein any of said steps of pushing comprises:
- pushing said holder block using a spring or any other pushing arrangement.

The holder block should be pushed firmly against the rivet, thereby exerting a pressure, the holder block is arranged through the top cavity of the mold of the molding step. This therefore requires the holder block to be held into place. This may be done using said spring, herein the spring or other pushing arrangement is arranged to exert a resulting pressure of the holder block onto the rivet, so that the rivet cavity is covered during the step of molding.

In an example of the disclosure, said step of molding comprises:
- molding the semiconductor package with said molding compound being an Epoxy Molding Compound, EMC.

It may be beneficial to mold the semiconductor package with an EMC, as it provides a strong adhesion to the surfaces of the semiconductor package. This ensures that the molded package is protected within the molded compound, preventing moisture ingress and mechanical failure.

Prior to and during the step of molding the EMC comprises a viscous, flowable state, wherein the EMC may be injected into a molding cavity provided by a top and bottom cavity. This allows said cavity to be fully filled. After this step, the EMC may be hardened, and the molding cavity may be removed.

In an example of the disclosure the method comprises the step of hardening the molding compound.

Once the cavity of the mold is filled, the epoxy may be kept under pressure and may be heat to cure. Curing may involve a chemical reaction that solidifies the epoxy, turning it into a rigid, protective layer.

In a second aspect of the disclosure, there is provided a semiconductor package manufactured in a method in accordance with the disclosure.

In an example of the disclosure, the connection pin is clamped by the rivet.

As mentioned, it may be beneficial to have the connection pin be clamped by the rivet. This allows a stable and secure connection between the rivet and the connection pin, thereby the further semiconductor as a whole.

In an example of the disclosure, the cavity of the rivet is partly filled.

The resulting cavity, with the received rivet, may not be entirely filled. This is because in order to firmly and tightly fil the connection pin inside of the rivet cavity, the connection pin must be pushed until it cannot be pushed more. If there is provided no gap between the connection pin and the bond pad, therefore no cavity, it might be that the connection pin actually still could be pushed further. This then may lead to an unstable and unsecure connection, wherein the connection pin may not be fully clamped tight. This is unwanted as it might compromise the reliability and electrical performance of the semiconductor package. Therefore, the rivet cavity may not be fully filled.

In an example of the disclosure, the rivet comprises an electrically conductive material arranged for providing an electrical connection between the bond pad and the connection pin.

It may be important that the rivet comprises an electrically conductive material, this is because in order to relay a signal or to provide power, an electrical connection needs to be made from the connection pin to the semiconductor material. As the connection pin may not be attached to the bond pad, there needs to be an electrically conductive material in between, which the rivet may provide.

In an example of the disclosure, wherein an encapsulant formed in the step of molding comprises a vertical offset between a top surface of the encapsulant and a top surface of the rivet.

It may be provided that there is a resulting vertical offset between the top surface of the encapsulant and the top surface of the rivet, this is because the cover is removed after the molding step. This vertical offset in a semiconductor package may indicate the presence of a cover during the manufacturing of the semiconductor package.

In an example of the disclosure, the connection pins may be clean, as there is no need for an additional grinding step to remove excess molding compound. This may also apply to the rivet cavity and the rivet top surface, where there is no need to grind.

### Brief description of the figures

Fig. 1 depicts a molded semiconductor package, including top and bottom cavity, comprising rivets covered by a cover.
Fig.2 depicts a molded semiconductor package, comprising a step of providing connection pins.
Fig. 3 depicts a molded semiconductor package, including top and bottom cavity, comprising rivets covered by a cover.
Fig. 4 depicts a molded semiconductor package, including top and bottom cavity, comprising rivets covered by a spring clip.
Fig. 5 depicts a molded semiconductor package, including top and bottom cavity, comprising rivets covered by a holder block.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

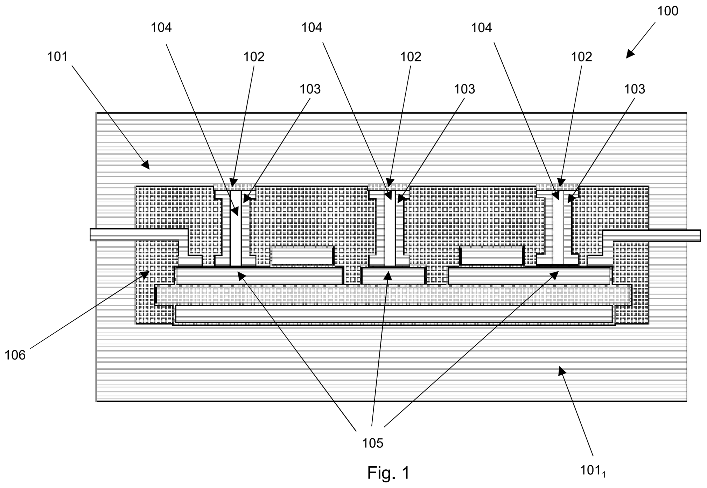

Fig. 1 depicts a molded semiconductor package 100, including top and bottom cavity 101, comprising rivets covered by a cover. Herein rivets 103 are provided on the semiconductor package, each on a bond pad 105. The rivets 103 each comprise a rivet cavity 104, arranged for receiving a connection pin (not shown here). On each of said rivets 103, a cover 102 is provided. This may be a film which sticks to the rivet top surface or another cover. This cover prevents the molding compound 106, such as a n epoxy molding compound, EMC, to enter the rivet cavity 104 during the molding process. During that process, the EMC is viscous and may creep into said rivet cavity 104, if not for the cover preventing this creep. After the molding step, the top and bottom cavity 101 may be removed.

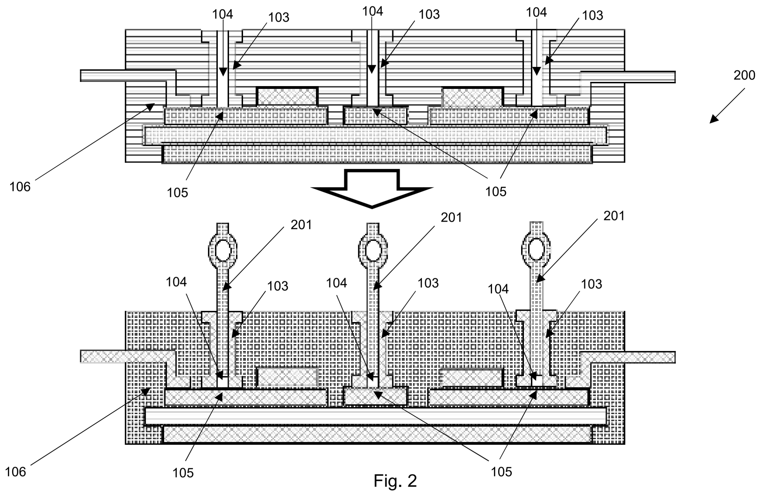

Fig.2 depicts a molded semiconductor package, comprising a step of providing connection pins. Herein rivets 103 are provided on the semiconductor package, each on a bond pad 105. The rivets 103 each comprise a rivet cavity 104, arranged for receiving a connection pin 201, such as a signal pin. After the step of molding the top and bottom cavities are removed, after this, the cover covering the rivet cavity 104 may be removed. This allows connection pins 201 to be provided in the rivet cavity 104.

Herein the connection pins 201 are each pushed into the rivet cavity 104₁, which is subsequently partly filled. The connection pins 201 each are clamped by the rivet 103, therefore may be of importance that the rivet cavity 104₁ is not entirely filled, otherwise that may signal that the connection pins 201 are not clamped firmly. This results in the semiconductor package 200 manufactured in accordance with the disclosure.

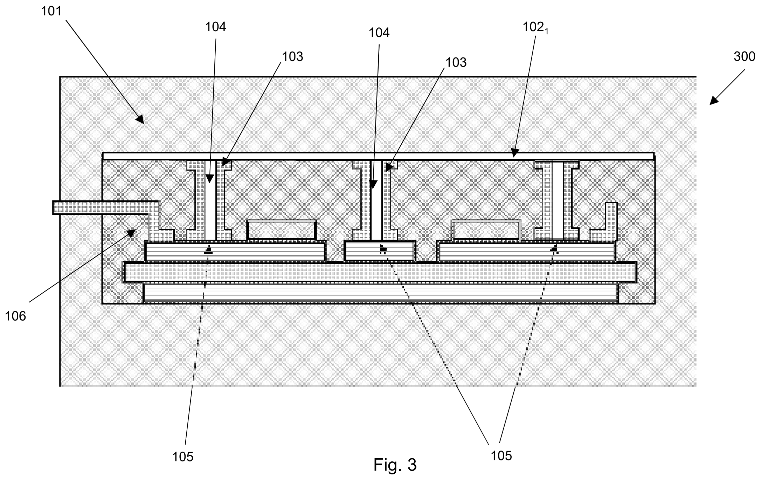

Fig. 3 depicts a molded semiconductor package, including top and bottom cavity, comprising rivets covered by a cover. Herein, the cover 102₁ covering the rivet cavities 104, comprises a cover 102₁ which is provided against the surface of the top cavity 101, prior to the molding process and is pushed against the rivets 103 during the molding process, such that a seal of the rivet cavity 104 is provided. This cover 102₁ may be a film. It is removed with the removal of the top cavity 101.

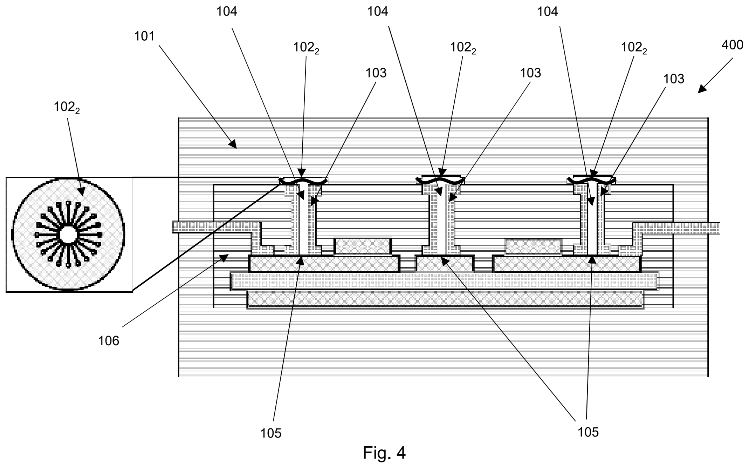

Fig. 4 depicts a molded semiconductor package, including top and bottom cavity, comprising rivets covered by a spring clip. Herein rivets 103 are provided on the semiconductor package, each on a bond pad 105. The rivets 103 each comprise a rivet cavity 104, arranged for receiving a connection pin (not shown here). On each of said rivets 103, a cover 102 is provided. In Fig. 4 this is a spring clip 102₂, which may also be observed in greater detail. The spring clip is pushed tight by the top and bottom cavity 101. This allows a full seal of the rivet cavity 104. The leaves of the spring clip intertwine after the pushing of the spring clip by the top and bottom cavity 101. Moreover, the side of the spring clip is solid. This spring clip prevents the molding compound 106, such as a n epoxy molding compound, EMC, to enter the rivet cavity 104 during the molding process. During that process, the EMC is viscous and may creep into said rivet cavity 104, if not for the spring clip preventing this creep. After the molding step, the top and bottom cavity 101 may be removed.

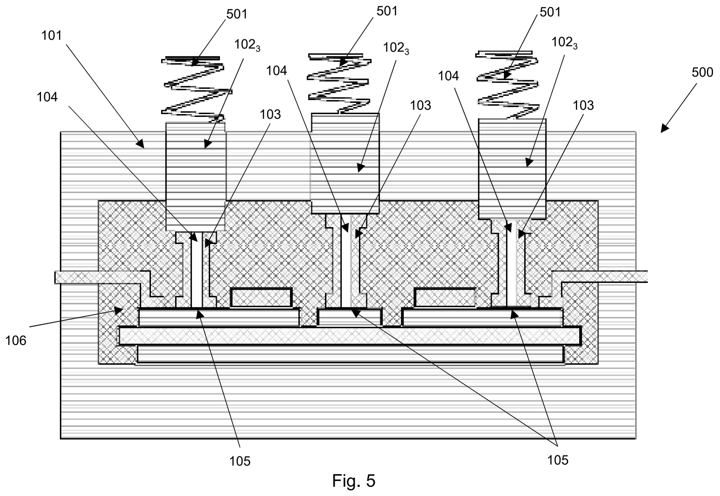

Fig. 5 depicts a molded semiconductor package, including top and bottom cavity, comprising rivets covered by a holder block. Herein rivets 103 are provided on the semiconductor package, each on a bond pad 105. The rivets 103 each comprise a rivet cavity 104, arranged for receiving a connection pin (not shown here). On each of said rivets 103, a cover 102 is provided. In Fig. 5, this is a holder block 102₃ , which passes through the top cavity and is pushed against the rivet top surface by a spring system 501, or any other pushing element. This example may be particularly useful when rivet top surfaces are not aligned, as the holder blocks 102₃ are pushed by the springs 501, they may have a variable position. In any case, this allows the rivet cavity 104 to be sealed, preventing any molding compound 106, such as a n epoxy molding compound, EMC, to enter the rivet cavity 104 during the molding process. It may also be provided that the holder block 102₃ is pushed against a cover (not shown here), such as a film. This cover may be a film or a spring clip, and may follow examples shown by the figures above. This combination may be beneficial as the covers, like films and spring clips may provide a superior shielding, while the holder block 102₃ prevents any EMC or any other molding compound to be on top of the cover, or at least above the rivet 103 and rivet cavity 104. After the molding step, the top and bottom cavity 101 may be removed. Prior to or before this step, the holder block 102₃ may be removed, but at least after the molding process has been completed. After removal of both the cover, comprising the holder block 102₃, and the top and bottom cavity 101, a connection pin may be provided in the rivet cavity 104 and clamped by the rivet 103.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims.

## Claims

1. A method of manufacturing a semiconductor package having a connection pin for creating a connection between the semiconductor package and an external circuit, comprising the steps of,
- providing said semiconductor package having a bond pad for receiving a rivet;
- mounting said rivet onto the bond pad of the semiconductor package, wherein the rivet is arranged to receive, in a rivet cavity of said rivet, said connection pin for creating said connection;
- molding the semiconductor package, having said mounted rivet, with a molding compound, wherein, during said molding, an opening of said rivet is covered by a cover, said opening leading to said rivet cavity;
- removing the cover and providing said connection pin in the rivet cavity via the rivet opening of said rivet.

2. A method in accordance with claim 1, wherein the step of mounting a rivet comprises
- mounting said rivet, said rivet comprising an electrically conductive material arranged for providing an electrical connection between the bond pad and the connection pin.

3. A method in accordance with claim 2, wherein said step of providing said connection pin comprises:
- providing said connection pin in the rivet cavity by clamping said connection pin by said rivet.

4. A method in accordance with claim 3, wherein said step of providing said connection pin comprises:
- providing said connection pin in the rivet cavity such that said cavity is partly filled.

5. A method in accordance with any of the previous claims, wherein said method comprises the step of:
- providing said cover on said rivet before said step of molding.

6. A method in accordance with claim 5, wherein said step of providing said cover comprises any of:
- providing a film on said rivet;
- providing a spring-clip on said rivet, wherein, during said step of molding, said spring-clip is pushed thereby providing a sealing of said rivet.

7. A method in accordance with any of the previous claims, wherein said method comprises any of the steps of:
- pushing a holder block against said cover, or
- pushing a holder block, being said cover, against said rivet, wherein said holder block is arranged for preventing, during said step of molding, molding compound to be provided above said rivet.

8. A method in accordance with claim 7, wherein any of said step of pushing comprises:
- pushing said holder block using a spring.

9. A method in accordance with any of the previous claims, wherein said step of molding comprises:
- molding the semiconductor package with said molding compound being an Epoxy Molding Compound, EMC.

10. A semiconductor package manufactured in a method in accordance with any of the previous claims.

11. A semiconductor package in accordance with claim 10, wherein the connection pin is clamped by the rivet.

12. A semiconductor package in accordance with claim 11, wherein the cavity of the rivet is partly filled.

13. A semiconductor package in accordance with any of the claims 10-12, wherein the rivet comprises an electrically conductive material arranged for providing an electrical connection between the bond pad and the connection pin.

14. A semiconductor package in accordance with any of the claims 10-13, wherein an encapsulant formed in the step of molding comprises a vertical offset between a top surface of the encapsulant and a top surface of the rivet.

15. A semiconductor package is accordance with any of the claims 10-14, wherein the semiconductor package comprises any of:
- Metal-Oxide-Semiconductor, MOS, Field-Effect-Transistor, FET;
- Bipolar, Junction, Transistor, BJT;
- Diode.
